# FASCICULE DE BREVET EUROPEEN

(11) **EP 3 174 151 B1**
(45) Date de publication et mention de la délivrance du brevet: **12.06.2019**
(21) Numéro de dépôt: 16200578.9
(22) Date de dépôt: 24.11.2016
(51) Int. Cl.: H01M 8/2465, C25B 9/18, H01R 12/70, H01R 12/77, H01R 13/621, H01R 13/639, H01M 8/04537, H01M 8/1018, H01R 101/00

(54) **CONNECTEUR ELECTRIQUE ET REACTEUR ELECTROCHIMIQUE MUNI D'UN TEL CONNECTEUR ELECTRIQUE**
ELEKTRISCHER ANSCHLUSS UND ELEKTROCHEMISCHER REAKTOR, DER MIT EINEM SOLCHEN ELEKTRISCHEN ANSCHLUSS AUSGESTATTET IST
ELECTRICAL CONNECTOR AND ELECTROCHEMICAL REACTOR PROVIDED WITH SUCH AN ELECTRICAL CONNECTOR

(30) Priorité: 27.11.2015 FR 1561515
(43) Date de publication de la demande: 31.05.2017
(73) Titulaire: Commissariat à l'Énergie Atomique et aux Énergies Alternatives, 75015 Paris (FR)
(72) Inventeur: POIROT-CROUVEZIER, Jean-Philippe, 38450 SAINT GEORGES DE COMMIERS (FR); GARNIER, Laurent, 69970 MARENNES (FR); ORIOL, Jean, 94420 LE PLESSIS-TREVISE (FR); ROBERT, Mickaël, 38570 GONCELIN (FR)
(74) Mandataire: GIE Innovation Competence Group

(56) Documents cités:
- EP-A2- 1 215 766
- JP-A- 2001 256 991
- JP-A- 2010 027 239
- US-A1- 2010 159 743

## Description

### DOMAINE TECHNIQUE

Le domaine de l'invention est celui des réacteurs électrochimiques, tels que les piles à combustible et les électrolyseurs, comportant un empilement de cellules électrochimiques, et concerne plus particulièrement la connexion électrique d'au moins l'une des cellules électrochimiques en vue notamment de mesurer une valeur de la polarisation électrique de la cellule électrochimique. L'invention s'applique par exemple à l'évaluation et au suivi de l'état de santé d'une cellule électrochimique.

### ÉTAT DE LA TECHNIQUE ANTÉRIEURE

Un réacteur électrochimique, tel qu'une pile à combustible ou un électrolyseur, comporte habituellement un empilement de cellules électrochimiques dont chacune comprend une anode et une cathode séparées électriquement l'une de l'autre par un électrolyte, les cellules étant le lieu d'une réaction électrochimique entre deux réactifs introduits de manière continue.

Dans le cas d'une pile à combustible, le combustible (par exemple l'hydrogène) est apporté jusqu'à l'anode alors que le comburant (par exemple l'oxygène) est amené à la cathode. La réaction électrochimique est subdivisée en deux demi-réactions, une réaction d'oxydation et une réaction de réduction, qui ont lieu respectivement à l'interface anode/électrolyte et à l'interface cathode/électrolyte. Pour avoir lieu, la réaction électrochimique requiert la présence d'un conducteur ionique entre les deux électrodes, à savoir l'électrolyte par exemple contenu dans une membrane polymère, et un conducteur électronique formé par le circuit électrique externe. L'empilement de cellules est ainsi le lieu de la réaction électrochimique : les réactifs doivent y être apportés, les produits et les espèces non réactives doivent en être évacués, tout comme la chaleur produite lors de la réaction.

Les cellules électrochimiques sont habituellement séparées les unes des autres par des plaques bipolaires qui assurent l'interconnexion électrique des cellules. Les plaques comportent habituellement une face anodique au niveau de laquelle est formé un circuit de distribution du carburant, et une face cathodique, opposée à la face anodique, au niveau de laquelle est formé un circuit de distribution du comburant. Chaque circuit de distribution prend la forme d'un réseau de canaux agencés par exemple en parallèle ou en serpentin pour amener l'espèce réactive de manière homogène à l'électrode correspondante. Les plaques bipolaires peuvent également comporter un circuit de refroidissement formé d'un réseau de conduits internes qui assurent l'écoulement d'un fluide caloporteur permettant d'évacuer la chaleur produite localement lors de la réaction par la cellule.

L'évaluation de l'état de santé du réacteur électrochimique peut nécessiter de mesurer une caractéristique électrique associée à l'une ou l'autre des cellules électrochimiques, telle que la tension ou l'impédance d'une cellule électrochimique. Une mesure de la polarisation électrique d'une plaque bipolaire de la cellule considérée est alors effectuée.

Le document US20030072983 décrit un exemple de connecteur électrique inséré dans un empilement de cellules électrochimiques. Les cellules comportent des plaques bipolaires dont la bordure latérale présente une structuration en forme de logement. Le connecteur électrique comporte une pluralité de parties dites d'extrémité destinées à être insérées dans les logements des plaques bipolaires, qui se prolongent par des parties dites externes reliant les parties d'extrémité à une carte électronique de mesure de la polarisation électrique. Les parties d'extrémité viennent contacter les plaques bipolaires dans les logements et une mesure de la polarisation électrique peut être effectuée.

Le document JP2007220338 décrit un autre exemple de connecteur électrique inséré dans un empilement de cellules électrochimiques. Les plaques bipolaires des cellules comportent également un logement situé en bordure latérale ainsi qu'un bossage de maintien faisant saillie dans le logement. Les parties d'extrémité du connecteur électrique comportent chacune une échancrure destinée à venir au contact du bossage de maintien lorsque les parties d'extrémité sont engagées dans les logements des plaques bipolaires.

Les documents JP2010027239 et JP2001256991 décrivent aussi des connecteurs électriques servant à la détection de tension dans des cellules électrochimiques.

Il existe cependant un besoin pour améliorer la fiabilité de la mesure électrique par le connecteur électrique, celle-ci dépendant notamment de la qualité du contact mécanique entre le connecteur électrique et la plaque bipolaire. Il existe également un besoin pour un connecteur électrique qui soit compatible avec des cellules électrochimiques de faible épaisseur.

### EXPOSÉ DE L'INVENTION

L'invention a pour objectif de remédier au moins en partie aux inconvénients de l'art antérieur, et plus particulièrement de proposer un connecteur électrique qui présente une tenue mécanique améliorée lorsqu'il occupe une position dite engagée dans l'empilement de cellules électrochimiques, améliorant ainsi la fiabilité de la mesure électrique par le connecteur électrique. Pour cela, l'objet de l'invention est un connecteur électrique, destiné à assurer une connexion électrique avec une cellule électrochimique d'un empilement de cellules électrochimiques, chaque cellule électrochimique comportant deux électrodes séparées l'une de l'autre par un électrolyte, lesdites électrodes étant en contact électrique avec des plaques bipolaires, le connecteur électrique comportant une partie d'extrémité destinée à être insérée dans l'empilement de cellules électrochimiques pour occuper une position dite engagée.

Ladite partie d'extrémité comporte une portion de contact électrique, destinée à être en contact électrique avec une plaque bipolaire de ladite cellule électrochimique lorsque la partie d'extrémité occupe la position engagée ; et une portion de blocage, destinée à coopérer avec ladite cellule électrochimique pour assurer un maintien de la partie d'extrémité dans la position engagée.

La portion de blocage comporte soit un orifice traversant de blocage destiné à recevoir par insertion un organe de butée de la cellule électrochimique, soit un organe de blocage destiné à être introduit par insertion dans un orifice traversant de butée de la cellule électrochimique ; ladite insertion, lorsque la partie d'extrémité occupe la position engagée, entraînant la formation d'une butée s'opposant au retrait de la partie d'extrémité hors de la position engagée.

Selon l'invention, la partie d'extrémité est formée d'un câble électrique comportant une âme conductrice sous forme de bande présentant deux faces opposées l'une à l'autre revêtue d'une gaine isolante, et peut présenter une épaisseur moyenne, entre deux faces principales de la partie d'extrémité sensiblement parallèles et opposées l'une à l'autre, inférieure aux dimensions de largeur et de longueur desdites faces principales.

Certains aspects préférés mais non limitatifs de ce connecteur électrique sont les suivants :
Ledit orifice traversant de blocage ou ledit organe de blocage peuvent s'étendre suivant une direction d'épaisseur de la partie d'extrémité, et est électriquement isolé de l'âme conductrice.

La portion de contact électrique et la portion de blocage peuvent être distinctes l'une de l'autre et être mutuellement espacées suivant un axe longitudinal du connecteur électrique.

La portion de blocage peut comporter un orifice traversant de blocage adapté à recevoir un organe de butée choisi parmi un centreur traversant l'empilement de cellules électrochimiques, un insert rapporté, et un bossage formé par ladite plaque bipolaire.

La portion de blocage peut comporter une fente traversante s'étendant à partir dudit orifice traversant de blocage jusqu'à une bordure latérale de la portion de blocage, ladite fente traversante présentant une largeur sensiblement inférieure au diamètre de l'orifice traversant de blocage.

Ledit orifice traversant de blocage de la portion de blocage peut s'étendre jusqu'à une bordure latérale de la portion de blocage au niveau d'une zone débouchante dudit orifice de blocage, celle-ci étant positionnée entre l'orifice traversant de blocage et la portion de contact électrique.

La portion de blocage peut comporter un organe de blocage sous forme d'un bossage adapté à être inséré dans un orifice traversant de butée de la cellule électrochimique.

La portion de contact électrique peut comporter une face principale, destinée à être orientée vers ladite plaque bipolaire, présentant une zone dépourvue de gaine isolante rendant libre une surface de contact de l'âme conductrice, ladite surface de contact étant destinée à être en contact électrique avec ladite plaque bipolaire.

Ladite surface de contact de l'âme conductrice peut présenter au moins une structuration en saillie vis-à-vis d'un plan principal suivant lequel s'étend sensiblement la surface de contact de l'âme conductrice, ladite structuration en saillie étant de préférence déformable élastiquement.

Le connecteur électrique peut comporter une pluralité de parties d'extrémités distinctes destinées à assurer une connexion électrique avec différentes plaques bipolaires, lesdites parties d'extrémités étant mécaniquement reliées à une même partie dite externe du connecteur électrique.

L'invention porte également sur un réacteur électrochimique, comportant :
- un empilement de cellules électrochimiques comportant chacune deux électrodes séparées l'une de l'autre par un électrolyte et en contact électrique avec des plaques bipolaires, et comportant au moins un organe de butée ou un orifice traversant de butée d'une cellule électrochimique ;
- au moins un connecteur électrique selon l'une quelconque des revendications précédentes, assurant une connexion électrique avec ladite cellule électrochimique, dont la partie d'extrémité est insérée dans l'empilement de cellules électrochimiques et occupe la position dite engagée, de sorte que l'orifice traversant de blocage reçoit par insertion ledit organe de butée ou de sorte que l'organe de blocage est introduit par insertion dans ledit orifice traversant de butée, ladite insertion entraînant la formation d'une butée s'opposant au retrait de la partie d'extrémité hors de la position engagée.

Lesdites plaques bipolaires peuvent comporter des bossages de contact, de préférence déformables élastiquement, la partie d'extrémité comportant une portion de contact au contact avec lesdits bossages de contact.

L'invention porte également sur un procédé de réalisation d'un réacteur électrochimique selon l'une ou l'autre des caractéristiques précédentes, comportant une étape de formation de l'empilement de cellules électrochimiques, au cours de laquelle, entre deux empilements de plaques bipolaires, on empile le connecteur électrique de telle manière que la partie d'extrémité occupe la position engagée, se traduisant par :
- un contact électrique entre la portion de contact électrique et une plaque bipolaire, et
- la formation d'une butée s'opposant au retrait de la partie d'extrémité hors de la position engagée par l'insertion dudit organe de butée dans l'orifice traversant de blocage ou par l'insertion dudit organe de blocage dans ledit orifice traversant de butée.

### BRÈVE DESCRIPTION DES DESSINS

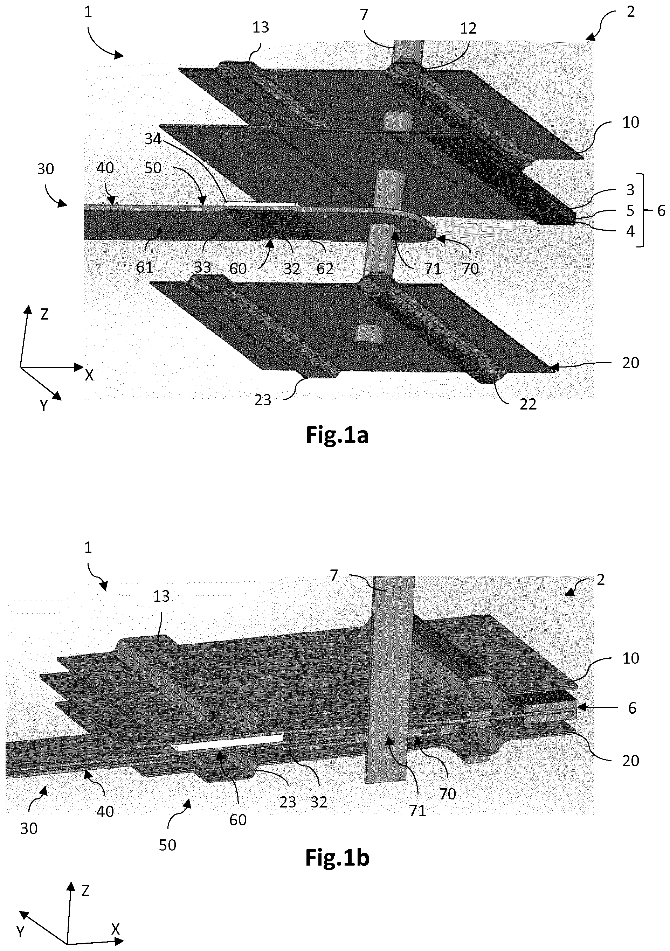

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure la est une illustration éclatée et en perspective d'une partie de réacteur électrochimique selon un mode de réalisation, où un connecteur électrique est inséré dans l'empilement de cellules électrochimiques ; la figure 1b est une illustration non éclatée de la même partie du réacteur électrochimique de la figure la ;
les figures 2a et 2b sont des vues en perspective du connecteur électrique illustré sur les figures la et 1b, où la portion de blocage est non déformée (figure 2a) et déformée (figure 2b) ;
la figure 3 est une vue en perspective du connecteur électrique selon une variante du mode de réalisation illustré sur les figures 2a et 2b ;
les figures 4a à 4f sont des vues schématiques en coupe longitudinale du blocage du connecteur électrique à la cellule électrochimique selon différentes variantes de réalisation, dans lesquelles la portion de blocage comporte :
   - un orifice traversant dit de blocage dans lequel est inséré un insert rapporté de butée solidaire de la cellule électrochimique (figures 4a et 4b) ;
   - un orifice traversant dit de blocage dans lequel est inséré un bossage de butée d'une plaque bipolaire de la cellule électrochimique (figures 4c et 4d) ;
   - un organe dit de blocage inséré dans un orifice traversant de butée d'une plaque bipolaire de la cellule électrochimique (figures 4e et 4f) ;

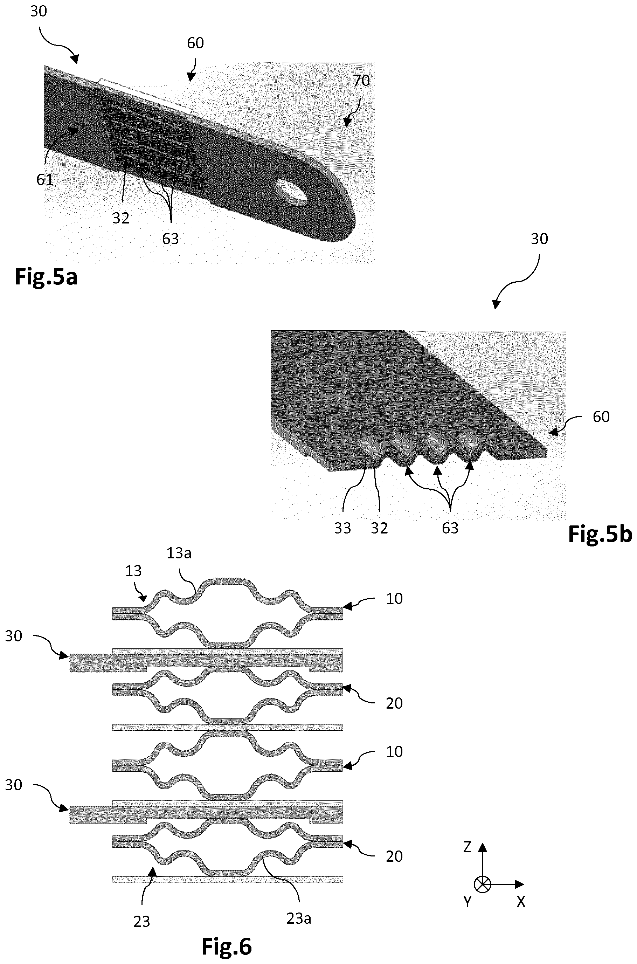

les figures 5a et 5b sont des vues en perspective de deux variantes du connecteur électrique dans lequel la portion de contact électrique comporte des structurations de l'âme conductrice faisant saillie vis-à-vis d'un plan principal de la partie d'extrémité du connecteur électrique ;
la figure 6 est une vue schématique en coupe longitudinale d'une zone de contact du connecteur électrique à la cellule électrochimique selon un autre mode de réalisation, dans lequel les plaques bipolaires comportent des bossages de contact déformables élastiquement ;

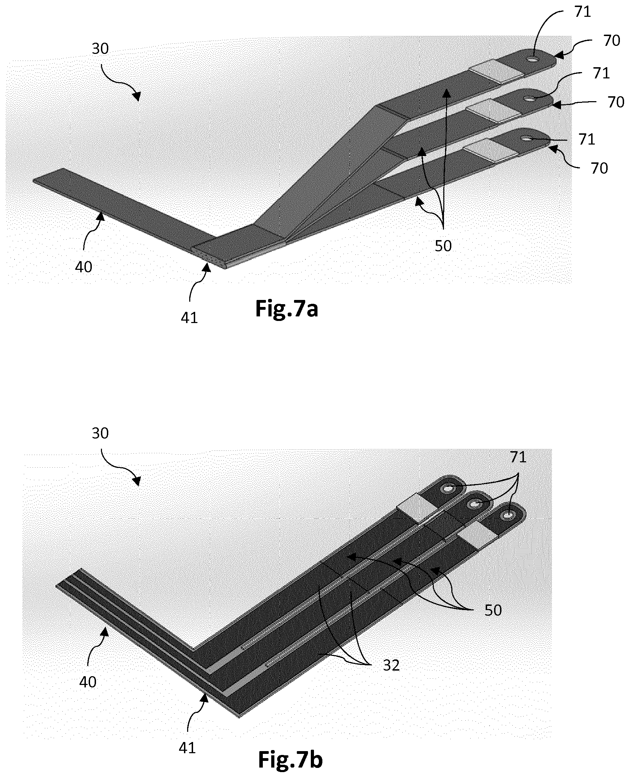

les figures 7a et 7b sont des vues en perspective d'un connecteur électrique selon un autre mode de réalisation dans lequel plusieurs parties d'extrémité sont reliées mécaniquement à une même partie dite externe du connecteur électrique.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures.
On décrira différents modes de réalisation et variantes en référence à une pile à combustible, et en particulier à une pile à hydrogène dont la cathode est alimentée en oxygène et l'anode en hydrogène. L'invention s'applique d'une manière générale à tout type de pile à combustible, en particulier à celles fonctionnant à basse température, c'est-à-dire à une température inférieure à 250°C, ainsi qu'aux électrolyseurs électrochimiques, et de manière générale à tout type de réacteur électrochimique comportant un empilement de cellules électrochimiques.

La figure la est une vue éclatée d'une partie d'une pile à combustible 1 selon un mode de réalisation, la pile à combustible comportant un empilement de cellules électrochimiques 2 dans lequel est inséré un connecteur électrique 30.
On définit ici et pour la suite de la description un repère orthonormé tridimensionnel (X,Y,Z), où les axes X et Y sont orientés suivant un plan principal suivant lequel s'étendent les cellules électrochimiques, et l'axe Z est orienté de manière sensiblement orthogonale au plan principal des cellules.
Les cellules électrochimiques 2 sont de préférence identiques les unes aux autres. Elles comportent chacune une anode 3 et une cathode 4 séparées l'une de l'autre par un électrolyte 5 ici contenu dans une membrane polymère électriquement isolante. L'ensemble des électrodes et de la membrane électrolytique est appelé par la suite AME 6 pour Assemblage Membrane Electrodes. L'anode, la membrane et la cathode sont des éléments classiques connus de l'homme du métier et ne sont pas décrits en détail. L'AME 6 s'étend suivant un plan principal de cellule ici sensiblement parallèle au plan (X,Y).

Chaque AME 6 est disposé entre des séparateurs 10, 20 appelés par la suite plaques bipolaires. Les plaques bipolaires 10, 20 comportent chacune une première face principale, dite face anodique, destinée à être partiellement au contact d'une anode 3 et une seconde face principale opposée à la face anodique, dite face cathodique, destinée à être partiellement au contact d'une cathode 4. Chaque plaque bipolaire assure la transmission du courant électrique entre les cellules électrochimiques et présente ainsi une valeur de polarisation électrique que l'on peut souhaiter mesurer.
Les plaques bipolaires 10, 20 sont ici formées chacune de deux parties assemblées l'une à l'autre, par exemple de deux tôles électriquement conductrices dont les bossages, réalisés notamment par emboutissage, forment des conduits de distribution des espèces réactives et des conduits de refroidissement. En variante, les deux parties assemblées peuvent être réalisées en un matériau composite chargé par exemple de graphite, où les bossages sont obtenus par moulage.
Sur la figure la est représentée une partie d'une cellule électrochimique 2 de l'empilement de cellules, dont on souhaite ici mesurer une valeur de polarisation électrique. Les plaques bipolaires 10, 20 présentent une étendue surfacique supérieure à celle de l'AME de sorte qu'elles présentent une bordure latérale qui entoure l'AME 6.
Dans cet exemple, la membrane 5 présente une étendue surfacique sensiblement égale à celle des plaques bipolaires 10, 20 et s'étend également jusqu'à la bordure latérale de ces dernières. Elle assure l'isolation électrique entre les deux plaques bipolaires. De manière alternative, la membrane 5 peut comporter en outre une feuille additionnelle formant un renfort local périphérique, voire être formée d'une seule feuille formant un renfort local, distincte de la membrane électrolytique de l'AME 6.
De manière à assurer la tenue mécanique de l'empilement de cellules électrochimiques, les plaques bipolaires comportent ici des premiers bossages 12, 22 entourant l'AME 6 et agencés de manière à être en contact mutuel par l'intermédiaire de la membrane et de joints périphériques. Les plaques bipolaires comportent ici des seconds bossages 13, 23, dits de contact, situés au niveau de la bordure latérale de la cellule électrochimique et entourant les premiers bossages 12, 22. Les bossages de contact 13, 23 sont ici en contact mutuel par l'intermédiaire de la membrane 5, et localement par l'intermédiaire d'un connecteur électrique 30.

De plus, de manière à assurer la tenue mécanique de l'empilement de cellules électrochimiques et en particulier pour assurer le positionnement mutuel des cellules électrochimiques dans le plan (X,Y), un insert 7 est introduit dans une ouverture traversante des plaques bipolaires 10, 20 et s'étend suivant l'axe Z d'empilement des cellules électrochimiques. Cet insert 7 est une tige rigide, appelé par la suite centreur ou tirant, et peut participer à appliquer une force de compression à l'empilement de cellules électrochimiques. Le centreur 7 est ici situé entre les premiers bossages 12, 22 et les bossages de contact 13, 23.
Dans le but d'assurer une connexion électrique entre la cellule électrochimique et une carte électronique de mesure ou d'application d'un potentiel électrique, un connecteur électrique 30 est inséré dans l'empilement de cellules au niveau de la cellule électrochimique 2, ici entre les deux plaques bipolaires 10, 20 de cette dernière.
Le connecteur électrique 30 comporte une partie dite externe 40 et une partie dite d'extrémité 50. La partie d'extrémité 50 est insérée dans l'empilement de cellules et est reliée à une carte électronique (non représentée) par l'intermédiaire de la partie externe 40, la carte électronique étant destinée à mesurer ou appliquer un potentiel électrique à la cellule électrochimique.
Le connecteur électrique 30, et en particulier la partie d'extrémité 50, se présente sous la forme d'un câble électrique sensiblement plat, dans le sens où il présente une épaisseur moyenne inférieure à ses dimensions de largeur et de longueur. Il comporte deux faces principales sensiblement parallèles et opposées l'une à l'autre, dont la distance relative définit l'épaisseur moyenne du connecteur électrique. Par ailleurs, il comporte une âme conductrice 32 sous forme d'une bande sensiblement plate dont les deux faces sont revêtues d'une gaine isolante 33. Par câble électrique, on entend un ensemble formé d'une âme conductrice recouverte par une gaine isolante. Par recouverte, ou revêtue, on entend que les deux faces principales de l'âme conductrice sont recouvertes par la gaine isolante sur toute leur surface, hormis dans au moins une zone destinée à assurer le contact électrique entre l'âme conductrice et une plaque bipolaire.
Le câble électrique peut être un câble plat flexible réalisé par laminage. L'âme conductrice 32 peut être réalisée à partir d'un feuillard de métal, par exemple du cuivre ou de l'aluminium d'une épaisseur moyenne de l'ordre de 10µm à 500µm. La gaine isolante 33 est réalisée en un matériau électriquement isolant, par exemple du polyimide d'une épaisseur moyenne de l'ordre de 10µm à 500µm. Le câble électrique peut présenter une épaisseur moyenne comprise entre 20µm et 1mm, et de préférence comprise entre 20µm et 500µm, par exemple comprise entre 100µm et 200µm. Il peut présenter une largeur comprise entre 5mm et 5cm, par exemple égale à 1cm.
La partie d'extrémité 50 du connecteur électrique comporte une portion de contact électrique 60 et une portion de blocage 70, distinctes et espacées l'une de l'autre suivant l'axe longitudinal du connecteur électrique.
Lorsque la partie d'extrémité 50 est insérée dans l'empilement de cellules électrochimiques et occupe une position dite engagée, la portion de contact électrique 60 est en contact électrique avec une plaque bipolaire 20 de la cellule électrochimique. Dans cet exemple, la portion de contact électrique 60 comporte une face principale 61 orientée vers la plaque bipolaire 20 à contacter dont une zone est dépourvue de gaine isolante 33, rendant ainsi libre une surface de contact 62 de l'âme conductrice 32. La surface de contact 62 est ici en contact direct avec le bossage de contact 23 de la plaque bipolaire 20. Ainsi, un contact électrique est assuré entre l'âme conductrice 32 et la plaque bipolaire 20. Plus précisément, la gaine isolante 30 revêt l'âme conductrice 32 sur les deux faces principales de cette dernière, et s'étend sur toute l'étendue longitudinale de la partie d'extrémité 50, hormis ici dans la zone de la surface de contact 62. Elle recouvre ainsi la face principale 61 ainsi que la face principale opposée, sur toute la longueur de la partie d'extrémité 50. La gaine isolante 30 est de préférence fixée à l'âme conductrice 32 de manière inamovible.
De plus, lorsque la partie d'extrémité 50 est insérée dans l'empilement de cellules électrochimiques et occupe une position dite engagée, la portion de blocage 70 coopère avec la cellule électrochimique pour assurer le maintien de la partie d'extrémité 50 dans la position engagée. Dans cet exemple, la portion de blocage 70 comporte un orifice traversant dit de blocage 71 s'étendant suivant la direction d'épaisseur du connecteur électrique, dans lequel est inséré un organe de butée 7 de la cellule électrochimique. L'organe de butée est ici le centreur 7, celui-ci étant solidaire de la cellule électrochimique. Ainsi, l'insertion du centreur de butée 7 dans l'orifice traversant de blocage 71 du connecteur électrique entraîne la formation d'une butée s'opposant au retrait de la partie d'extrémité 50 hors de la position engagée et donc hors de l'empilement de cellules électrochimiques.
L'orifice traversant de blocage 71 présente une forme avantageusement complémentaire de celle du centreur de butée 7. Elle est ici sensiblement circulaire mais d'autres formes sont possibles, par exemple ovale, oblongue, voire polygonale. Le diamètre de l'orifice de blocage est ici une grandeur associée au périmètre de l'orifice. Il peut s'agir du diamètre d'un disque présentant la même surface que celle de l'orifice traversant 71.
L'orifice traversant de blocage 71 est de préférence électriquement isolé de l'âme conductrice 32. Pour cela, il est ici défini par une portion de gaine isolante 33 sur toute l'épaisseur de la portion de blocage 70, évitant ainsi tout contact électrique entre l'âme conductrice 32 et le centreur de butée 7, ce contact électrique étant susceptible de perturber la connexion électrique entre l'âme conductrice et la plaque bipolaire.
Par ailleurs, le connecteur électrique 30 comporte ici une couche d'appui 34 située au niveau de la portion de contact électrique 60 et positionnée au niveau de la face principale opposée à la surface de contact 62. Ainsi, la couche d'appui 34 est intercalée entre la gaine isolante 33 et le bossage de contact 13 de la plaque bipolaire 10, et est avantageusement réalisée en un matériau électriquement isolant. Elle assure ainsi un meilleur contact mécanique et donc électrique entre l'âme conductrice 32 et la plaque bipolaire 20. La couche d'appui 34 peut être réalisée en un matériau élastique de manière à s'adapter aux tolérances d'épaisseur et aux dilatations thermiques des plaques bipolaires et du connecteur électrique. Elle peut ainsi être réalisée en un élastomère et/ou en une mousse expansée.

La figure 1b est une vue en perspective de la partie de pile à combustible illustrée sur la figure 1a, dans laquelle les différents éléments sont en contact mutuel.
La partie d'extrémité 50 est en position engagée, de sorte que la portion de contact électrique 60 est telle que l'âme conductrice 32 est en contact électrique avec la plaque bipolaire 20 au niveau du bossage de contact 23, et de sorte que la portion de blocage 70 est telle que l'orifice traversant de blocage 71 reçoit par insertion le centreur de butée 7.

Ainsi, la partie d'extrémité 50 du connecteur électrique est bloquée en déplacement suivant les directions X, Y, Z, et ne peut être désengagée et retirée de l'empilement de cellules électrochimiques. En effet, la partie d'extrémité 50 est bloquée en déplacement suivant l'axe Z d'empilement des cellules par le contact mécanique avec les bossages de contact 13, 23 des plaques bipolaires. De plus, elle est bloquée en translation dans le plan (X,Y) par la butée formée entre le centreur de butée 7 et l'orifice traversant de blocage 71 de la portion de blocage.
Le connecteur électrique 30 présente ainsi, lorsqu'il occupe la position engagée, un maintien mécanique amélioré qui entraîne une qualité accrue de la connexion électrique et donc une plus grande fiabilité des mesures ou applications du potentiel électrique. En effet, lorsque la partie d'extrémité occupe la position engagée, les chocs et vibrations que peut subir la pile à combustible en fonctionnement ne peuvent provoquer le retrait du connecteur électrique hors de l'empilement de cellules.
De plus, le connecteur électrique présentant une forme de câble électrique sensiblement plat, il peut être inséré entre les plaques bipolaires sans induire de surépaisseur importante à l'empilement de cellules. Il peut également être introduit entre les plaques bipolaires dans une zone où ces dernières sont habituellement en contact mécanique, par exemple entre les bossages de contact.

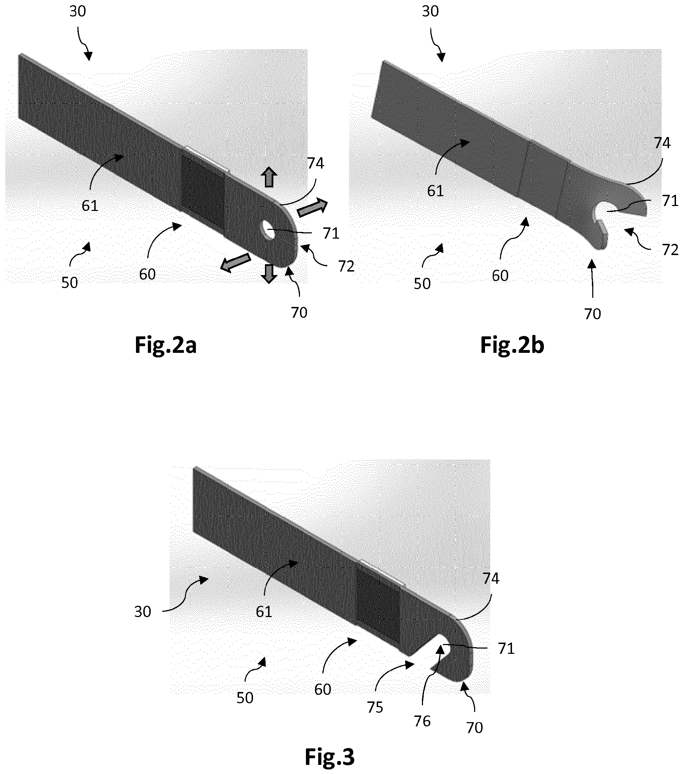

Les figures 2a et 2b sont des vues en perspective du connecteur électrique tel qu'illustré sur les figures 1a et 1b, qui représentent un exemple de structuration permettant d'insérer le centreur de butée dans l'orifice traversant de blocage de la partie d'extrémité.
Dans cet exemple, la portion de blocage 70 comporte une fente traversante 72 qui s'étend à partir de l'orifice de blocage 71 jusqu'à une bordure latérale 74 de la portion de blocage 70, ici située dans le prolongement longitudinal de l'orifice traversant de blocage 71. La fente 72 présente une largeur sensiblement inférieure au diamètre de l'orifice traversant de blocage 71, la largeur étant définie comme l'espacement entre les deux branches de la portion de blocage 70 en regard l'une de l'autre au niveau de la fente 72.

La portion de blocage 70 est ici déformable élastiquement, de sorte que l'application de forces d'écartement au niveau de la fente 72, orientées par exemple suivant les flèches représentées sur la figure 2a, conduit à l'ouverture de la portion de blocage (figure 2b), permettant ainsi au centreur de butée 7 d'être inséré dans l'orifice traversant de blocage 71.
Une fois le centreur de butée 7 inséré dans l'orifice traversant de blocage 71, la portion de blocage 70 reprend sa forme initiale de sorte que le centreur de butée 7 est continûment entouré par la portion de blocage 70. Une butée est alors formée entre le centreur 7 et le connecteur électrique 30, qui s'oppose alors au retrait de la partie d'extrémité 50 hors de la position engagée.

Un procédé de réalisation de la pile à combustible telle que partiellement illustrée sur la figure 1b est maintenant décrit.
Les différents éléments des cellules électrochimiques sont empilés successivement les uns sur les autres le long du centreur 7. Ainsi, la plaque bipolaire 20 est empilée sur une cellule électrochimique précédente et est traversée par le centreur 7.
Ensuite on empile le connecteur électrique 30 de sorte que la partie d'extrémité 50 occupe la position engagée. La portion de contact électrique 60 est alors en contact électrique avec le bossage de contact 23 de la plaque bipolaire 20 et l'orifice traversant de blocage 71 reçoit par insertion le centreur de butée 7.
Puis, on empile, sur la plaque bipolaire 20 et la partie d'extrémité 50 du connecteur électrique, l'AME 6 puis la plaque bipolaire 10. La membrane 5 est alors en contact mécanique avec la portion de contact électrique 60 au niveau de la couche d'appui 34. Le bossage de contact 13 de la plaque bipolaire 10 est aligné dans le plan (X,Y) avec celui 23 de la plaque bipolaire 20.
Enfin, les différents éléments des cellules électrochimiques suivantes sont empilés, de sorte à obtenir un empilement de cellules électrochimiques dans lequel est inséré le connecteur électrique.
Ainsi, le connecteur électrique 30 est bloqué en translation dans le plan (X,Y) par la butée formée par l'insertion du centreur de butée 7 dans l'orifice traversant de blocage 71, et suivant la direction Z par le contact mécanique avec les plaques bipolaires 10, 20 au niveau des bossages de contact 13, 23. La connexion électrique est alors robuste vis-à-vis des vibrations et chocs que la pile à combustible est susceptible de subir lors de son fonctionnement, sans que ces derniers n'affectent le maintien mécanique du connecteur électrique dans sa position engagée ni ne dégradent la qualité de la connexion électrique avec la cellule électrochimique.

La figure 3 est une variante de réalisation du connecteur électrique 30 tel qu'illustré précédemment, qui s'en distingue essentiellement en ce que l'orifice traversant de blocage 71 s'étend entre une zone principale de blocage 76 située sensiblement au centre de la portion de blocage 70 et une zone débouchante 75 située au niveau de la bordure latérale 74 de la portion de blocage 70. L'orifice traversant de blocage 71 présente ici une largeur sensiblement constante, et avantageusement égale ou supérieure au diamètre transversal du centreur de butée 7.
Par ailleurs, la zone débouchante 75 est avantageusement située en amont de la zone principale 76 en direction de la partie externe 40 du connecteur électrique. Ainsi, lorsque le centreur de butée 7 est inséré dans l'orifice de blocage 71, une force de retrait conduit le centreur 7 à occuper la zone principale 76 et à venir en butée contre une bordure interne de l'orifice de blocage 71. Ainsi, une butée se forme entre le connecteur électrique et le centreur qui s'oppose au retrait de la partie d'extrémité hors de la position engagée.

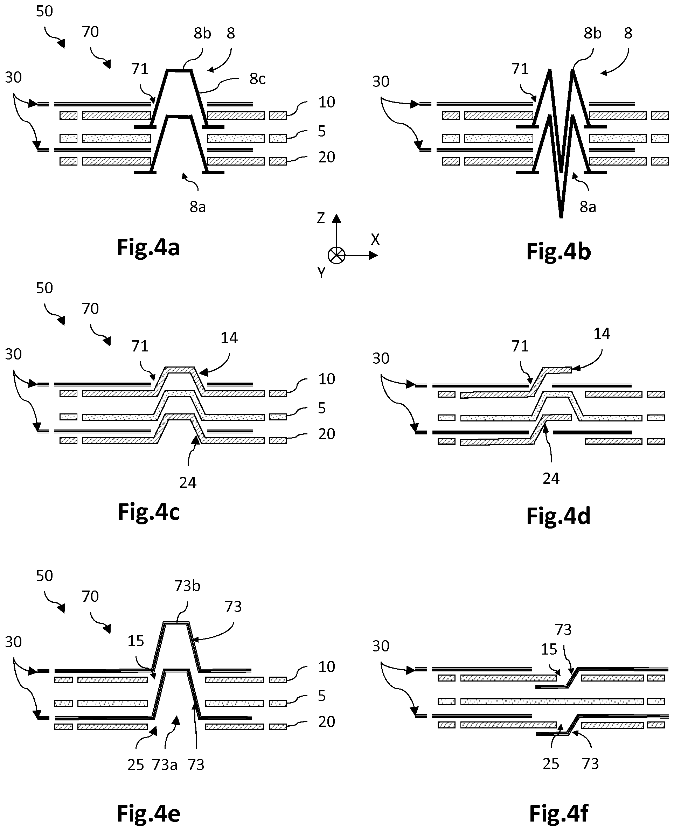

Les figures 4a à 4f sont des vues schématiques en coupe longitudinale d'une zone de blocage du connecteur électrique à la cellule électrochimique selon différentes variantes de réalisation.
Les figures 4a et 4b illustrent deux variantes dans lesquelles la portion de blocage 70 du connecteur électrique 30 comporte un orifice traversant de blocage 71 dans lequel est inséré un insert rapporté 8 de butée, solidaire de la cellule électrochimique.
La plaque bipolaire 20 en regard de laquelle se situe le connecteur électrique 30 présente ici un orifice traversant 26 aligné dans le plan (X,Y) avec l'orifice de blocage 71, ces orifices recevant l'insert rapporté 8. Celui-ci est donc solidaire de la cellule électrochimique et forme une butée vis-à-vis de la partie d'extrémité 50 du connecteur électrique, bloquant celle-ci en translation dans le plan (X,Y). Dans cet exemple, la membrane 5 comporte également un orifice traversant aligné sur les orifices et reçoit également l'insert rapporté 8.
L'insert rapporté 8 est ici une pièce mécanique formant un bossage en saillie vis-à-vis du plan principal (X,Y) de la cellule électrochimique, qui s'étend suivant l'axe Z d'empilement des cellules. Elle présente ici une forme tronconique creuse dont la dimension transversale dans le plan (X,Y) est sensiblement égale au diamètre de l'orifice de blocage. La section transversale, dans le plan (X,Y), de l'insert rapporté 8 est ici circulaire de révolution mais d'autres formes sont possibles, par exemple ovale, oblongue, voire polygonale. L'insert rapporté 8 peut assurer la butée vis-à-vis d'une ou de plusieurs parties d'extrémité distinctes. Il peut s'étendre sur l'épaisseur d'une ou de plusieurs cellules électrochimiques.
Dans l'exemple de la figure 4a, l'insert rapporté 8 est de forme tronconique et présente une base 8a ouverte ainsi qu'un sommet 8b fermé reliant de manière sensiblement plane la paroi latérale 8c du tronc de cône. Plusieurs inserts rapportés 8 sont insérés dans l'empilement de cellules et alignés suivant l'axe Z. Pour assurer une meilleure tenue mécanique, les inserts rapportés 8 sont empilés les uns dans les autres suivant l'axe Z, de sorte que le sommet 8b d'un insert rapporté est inséré dans la base 8a de l'insert rapporté adjacent.
Dans l'exemple de la figure 4b, l'insert rapporté 8 présente une forme similaire de celle de l'insert représenté sur la figure 4a. Il s'en distingue essentiellement en ce que le sommet 8b présente un décrochement s'étendant suivant la direction -Z, ce décrochement étant structuré de manière à former une ouverture adaptée à recevoir le décrochement de l'insert rapporté adjacent. Ainsi, pour assurer une meilleure tenue mécanique, les inserts rapportés 8 sont empilés les uns dans les autres suivant l'axe Z de sorte que le décrochement du sommet 8b d'un insert rapporté est introduit dans l'ouverture formée par l'ouverture du sommet 8b de l'insert rapporté adjacent.
Les figures 4c et 4d illustrent deux variantes dans lesquelles la portion de blocage 70 du connecteur électrique 30 comporte un orifice traversant de blocage 71 dans lequel est inséré un bossage de butée 14, 24 réalisé par la plaque bipolaire 10, 20 de la cellule électrochimique.
Le bossage de butée 14, 24 fait saillie vis-à-vis du plan principal (X,Y) de la cellule électrochimique et s'étend suivant l'axe Z d'empilement des cellules. Il est inséré dans l'orifice de blocage 71 de la partie d'extrémité 50 du connecteur électrique, assurant ainsi le blocage en translation de celui-ci dans le plan (X,Y).
Le bossage de butée 14, 24 peut être réalisé sous forme d'un décrochement continu de la plaque bipolaire 10, 20 (figure 4c) ou sous forme d'un décrochement discontinu (figure 4d) se traduisant par une ouverture localisée de la plaque bipolaire 10, 20.
Les figures 4e et 4f illustrent deux variantes dans lesquelles la portion de blocage 70 du connecteur électrique 30 comporte un organe de blocage 73 inséré dans un orifice traversant de butée 15, 25 d'une plaque bipolaire 10, 20 de la cellule électrochimique.
L'organe de blocage 73 est ici un bossage réalisé sous forme d'un décrochement continu (figure 4e) ou discontinu (figure 4f) de la portion de blocage 70, le décrochement s'étendant suivant l'axe Z d'empilement des cellules et étant inséré dans un orifice traversant de butée 15, 25 réalisé dans une plaque bipolaire 10, 20 de la cellule électrochimique.
Dans l'exemple de la figure 4e, l'organe de blocage 73 peut présenter une forme tronconique à section transversale dans le plan (X,Y) sensiblement circulaire, bien que les formes mentionnées précédemment peuvent être réalisées. Il présente ici une base 73a creuse formant une ouverture adaptée à recevoir le sommet 73b du bossage de blocage 73 adjacent.
Ainsi, l'insertion de l'organe de blocage 73 dans l'orifice traversant de butée 15, 25 de la cellule électrochimique conduit à la formation d'une butée s'opposant au retrait de la partie d'extrémité hors de la position engagée.

Les figures 5a et 5b sont des vues en perspective de la portion de contact électrique d'un connecteur électrique selon d'autres modes de réalisation, dans lesquelles la surface de contact de l'âme conductrice présente au moins une structuration en saillie vis-à-vis du plan principal suivant lequel elle s'étend, améliorant le contact électrique entre l'âme conductrice et la cellule électrochimique.
Dans l'exemple de la figure 5a, l'âme conductrice 32 présente plusieurs structurations 63 en saillie sous forme de portions 63 d'épaisseur supérieure à l'épaisseur moyenne de l'âme conductrice 32 hors desdites portions 63. Ainsi, le contact électrique a lieu principalement au niveau des portions épaissies 63 de l'âme conductrice, ce qui se traduit par une pression de contact mécanique accrue entre l'âme conductrice et la plaque bipolaire pour un même effort appliqué à la cellule électrochimique, améliorant ainsi la qualité du contact électrique notamment en réduisant la résistance électrique à l'interface entre l'âme conductrice et la plaque bipolaire.
Dans l'exemple de la figure 5b, la portion de contact électrique 60 présente plusieurs structurations 63 en saillie sous forme de bossages de l'âme conductrice et de la gaine isolante. L'âme conductrice 32 présente ici une épaisseur moyenne sensiblement constante au niveau de la surface de contact 62. Ainsi, de manière similaire à la variante de la figure 5a, le contact électrique a lieu principalement au niveau des bossages 63 de l'âme conductrice 32, ce qui se traduit par une pression de contact mécanique accrue entre l'âme conductrice et la plaque bipolaire pour un même effort appliqué à la cellule électrochimique, améliorant ainsi la qualité du contact électrique notamment en réduisant la résistance électrique à l'interface entre l'âme conductrice et la plaque bipolaire.
Bien entendu, ces structurations en saillie de l'âme conductrice peuvent être combinées entre elles et d'autres types de structurations peuvent être envisagés.

La figure 6 est une vue schématique en coupe longitudinale d'une zone de contact du connecteur électrique vis-à-vis de la cellule électrochimique selon un autre mode de réalisation, dans lequel les plaques bipolaires 10, 20 comportent des bossages de contact 13, 23 élastiquement déformables.
Les plaques bipolaires sont formées de deux tôles assemblées l'une à l'autre, et présentent des bossages de contact 13, 23 venant au contact mécanique de la partie d'extrémité 50 du connecteur électrique. Les bossages de contact 13, 23 peuvent présenter des structurations 13a, 23a conduisant à augmenter leur capacité à se déformer élastiquement.
La figure 6 présente un exemple de structurations 13a, 23a des bossages de contact 13, 23 sous forme d'ondulations des tôles formant les plaques bipolaires, mais d'autres exemples d'ondulations sont possibles. Ainsi, lorsqu'un effort de compression est appliqué aux cellules électrochimiques, les bossages de contact 13, 23 se déforment au niveau des structurations 13a, 23a, améliorant ainsi la qualité du contact mécanique et donc électrique entre les plaques bipolaires et la ou les parties d'extrémité.
Dans cet exemple, les bossages de contact se présentent sous forme de nervure s'étendant en périphérie de l'AME de la cellule électrochimique. En variante, ils peuvent se présenter sous forme de plots, par exemple cylindriques de résolution, situés dans diverses positions de la périphérie de l'AME.
Ces bossages de contact 13, 23 à structurations 13a, 23a permettent notamment de maintenir le contact mécanique local entre les cellules électrochimiques, quel que soit le nombre de parties d'extrémité 50 engagées dans l'empilement de cellules.

Les figures 7a et 7b sont des vues en perspective d'un connecteur électrique selon un autre mode de réalisation dans lequel plusieurs parties d'extrémité 50 sont reliées mécaniquement à une même partie externe 40 du connecteur électrique.
La partie externe 40 regroupe ainsi les différentes âmes conductrices 32 qui s'étendent chacune d'une carte électronique (non représentée) jusqu'aux parties d'extrémité 50 respectives.
La figure 7a illustre le connecteur électrique comportant des parties d'extrémité 50 disposées à être engagées dans l'empilement de cellules électrochimiques. Les différentes parties d'extrémité 50 sont superposées les unes aux autres de sorte que les orifices traversants de blocage 71 soient alignés suivant l'axe Z d'empilement des cellules. Elles se rejoignent au niveau d'une portion de jonction 41 commune dans laquelle les âmes conductrices 32 sont superposées et isolées les unes des autres par la gaine isolante 33. Les âmes conductrices 32 s'étendent ensuite dans la partie externe 40 en étant ici disposées côte à côte entre les deux faces principales de la partie externe.
La figure 7b illustre le connecteur électrique avant l'étape de positionnement des parties d'extrémité 50, cette étape étant ici réalisée par pliage au niveau de la portion de jonction 41. Une gaine isolante 33 recouvrant une face des âmes conductrices 32 est ici transparente pour mettre en évidence le cheminement des âmes conductrices 32 dans la partie externe 40, dans la portion de jonction 41 et dans les parties d'extrémité 50.

D'autres agencements des parties d'extrémité vis-à-vis de la partie externe sont possibles, par exemple entraînant davantage d'étapes de pliage au niveau de la portion de jonction.

Des modes de réalisation particuliers viennent d'être décrits. Différentes variantes et modifications apparaîtront à l'homme du métier.
Ainsi, on a décrit une partie d'extrémité comportant une seule âme conductrice, bien qu'elle puisse comporter plusieurs âmes conductrices, mutuellement superposées et/ ou latéralement décalées. Elles sont alors isolées les unes des autres par la gaine isolante. Ainsi, une telle partie d'extrémité peut être en contact électrique avec les deux plaques bipolaires d'une même cellule électrochimique lorsque la portion de contact électrique comporte deux surfaces de contact opposées l'une à l'autre. Une telle partie d'extrémité peut également assurer au moins deux contacts électriques avec la même plaque bipolaire lorsque la portion de contact électrique comporte plusieurs surfaces de contact situées sur la même face de la partie d'extrémité mais isolées l'une de l'autre. Il est alors possible d'appliquer un potentiel électrique et de mesurer la réponse électrique de la cellule dans le même temps.
Par ailleurs, on a décrit le contact électrique entre l'âme conductrice du connecteur et une plaque bipolaire d'une cellule électrochimique au niveau d'un bossage de contact. Alternativement, le contact électrique peut être réalisé par l'intermédiaire d'une pièce de renfort latéral muni d'une piste conductrice en contact électrique avec une plaque bipolaire ou une électrode d'une cellule électrochimique.
On a décrit principalement la mesure d'un potentiel électrique d'une cellule électrochimique, mais le connecteur électrique permet également d'appliquer un potentiel électrique, notamment lorsqu'on souhaite analyser le comportement électrochimique de la cellule par une méthode de type spectroscopie d'impédance ou voltampérométrie.

## Revendications

1. Réacteur électrochimique (1), comportant :
- un empilement de cellules électrochimiques (2) comportant chacune deux électrodes (3, 4) séparées l'une de l'autre par un électrolyte (5) et en contact électrique avec des plaques bipolaires (10, 20), et comportant au moins un organe de butée (7 ; 8 ; 14, 24) ou un orifice traversant de butée (15, 25) d'une cellule électrochimique ; et
- au moins un connecteur électrique (30), assurant une connexion électrique avec ladite cellule électrochimique (2) dudit empilement de cellules électrochimiques, le connecteur électrique comportant une partie d'extrémité (50) insérée dans l'empilement de cellules électrochimiques et occupant une position dite engagée, ladite partie d'extrémité comportant :
o une portion de contact électrique (60), étant en contact électrique avec une plaque bipolaire (10 ; 20) de ladite cellule électrochimique (2) lorsque la partie d'extrémité (50) occupe la position engagée ; et
o une portion de blocage (70), coopérant avec ladite cellule électrochimique (2) pour assurer un maintien de la partie d'extrémité (50) dans la position engagée,
**caractérisé en ce que** la portion de blocage (70) comporte :
▪ soit un orifice traversant de blocage (71) recevant par insertion ledit organe de butée (7 ; 8 ; 14, 24) de la cellule électrochimique,
▪ soit un organe de blocage (73) introduit par insertion dans ledit orifice traversant de butée (15 ; 25) de la cellule électrochimique,
ladite insertion, entraînant la formation d'une butée s'opposant au retrait de la partie d'extrémité (50) hors de la position engagée,
et **en ce que** la partie d'extrémité (50) est formée d'un câble électrique comportant une âme conductrice (32) sous forme de bande présentant deux faces opposées l'une à l'autre revêtue d'une gaine isolante (33), et présente une épaisseur moyenne, entre deux faces principales de la partie d'extrémité (50) sensiblement parallèles et opposées l'une à l'autre, inférieure aux dimensions de largeur et de longueur desdites faces principales.

2. Réacteur électrochimique selon la revendication 1, dans lequel ladite gaine isolante (33) s'étend au niveau des portions de contact électrique (60) et de blocage (70) sur lesdites deux faces principales de la partie d'extrémité (33).

3. Réacteur électrochimique selon la revendication 1 ou 2, dans lequel la partie d'extrémité (50) présente une épaisseur moyenne comprise entre 20µm et 500µm.

4. Réacteur électrochimique selon l'une quelconque des revendications 1 à 3, dans lequel ledit orifice traversant de blocage (71) ou ledit organe de blocage (73) s'étend suivant une direction d'épaisseur de la partie d'extrémité (50), et est électriquement isolé de l'âme conductrice (32) par ladite gaine isolante (33).

5. Réacteur électrochimique selon l'une quelconque des revendications 1 à 4, dans lequel la portion de contact électrique (60) et la portion de blocage (70) sont distinctes l'une de l'autre et mutuellement espacées suivant un axe longitudinal du connecteur électrique.

6. Réacteur électrochimique selon l'une quelconque des revendications 1 à 5, dans lequel la portion de contact électrique (60) comporte une face principale (61), orientée vers ladite plaque bipolaire (10, 20), présentant une zone dépourvue de gaine isolante (33) rendant libre une surface de contact (62) de l'âme conductrice (32), ladite surface de contact (62) étant en contact électrique avec ladite plaque bipolaire (10 ; 20).

7. Réacteur électrochimique selon la revendication 6, dans lequel la face de l'âme conductrice (32) opposée à la face principale (61) est revêtue de la gaine isolante (33).

8. Réacteur électrochimique selon la revendication 6 ou 7, dans lequel ladite surface de contact (62) de l'âme conductrice (32) présente au moins une structuration en saillie (63) vis-à-vis d'un plan principal suivant lequel s'étend sensiblement la surface de contact (62) de l'âme conductrice, ladite structuration en saillie (63) étant de préférence déformable élastiquement.

9. Réacteur électrochimique selon l'une quelconque des revendications 1 à 8, dans lequel la portion de blocage (70) comporte un orifice traversant de blocage (71) adapté à recevoir un organe de butée choisi parmi un centreur (7) traversant l'empilement de cellules électrochimiques, un insert rapporté (8), et un bossage (14, 24) formé par ladite plaque bipolaire.

10. Réacteur électrochimique selon la revendication 9, dans lequel la portion de blocage (70) comporte une fente traversante (72) s'étendant à partir dudit orifice traversant de blocage (71) jusqu'à une bordure latérale (74) de la portion de blocage, ladite fente traversante présentant une largeur sensiblement inférieure au diamètre de l'orifice traversant de blocage.

11. Réacteur électrochimique selon la revendication 9, dans lequel ledit orifice traversant de blocage (71) de la portion de blocage (70) s'étend jusqu'à une bordure latérale (74) de la portion de blocage au niveau d'une zone débouchante (75) dudit orifice de blocage (71), celle-ci étant positionnée entre l'orifice traversant de blocage (71) et la portion de contact électrique (60).

12. Réacteur électrochimique selon l'une quelconque des revendications 1 à 8, dans lequel la portion de blocage (70) comporte un organe de blocage (73) sous forme d'un bossage adapté à être inséré dans un orifice traversant de butée (15 ; 25) de la cellule électrochimique.

13. Réacteur électrochimique selon l'une quelconque des revendications 1 à 12, comportant une pluralité de parties d'extrémités (50) distinctes assurant une connexion électrique avec différentes plaques bipolaires (10, 20), lesdites parties d'extrémités étant mécaniquement reliées à une même partie dite externe (40) du connecteur électrique.

14. Réacteur électrochimique selon l'une quelconque des revendications 1 à 13, dans lequel lesdites plaques bipolaires (10, 20) comportent des bossages de contact (13, 23), de préférence déformables élastiquement, la partie d'extrémité (50) comportant une portion de contact (60) au contact avec lesdits bossages de contact (13, 23).

15. Procédé de réalisation d'un réacteur électrochimique (1) selon l'une quelconque des revendications 1 à 14, comportant une étape de formation de l'empilement de cellules électrochimiques, au cours de laquelle, entre deux empilements de plaques bipolaires (10, 20), on empile le connecteur électrique de telle manière que la partie d'extrémité occupe la position engagée, se traduisant par :
- un contact électrique entre la portion de contact électrique (60) et une plaque bipolaire (10, 20), et
- la formation d'une butée s'opposant au retrait de la partie d'extrémité hors de la position engagée par l'insertion dudit organe de butée (7 ; 8 ; 14, 24) dans l'orifice traversant de blocage (71) ou par l'insertion dudit organe de blocage (73) dans ledit orifice traversant de butée (15, 25).

## Patentansprüche

1. Elektrochemischer Reaktor (1), umfassend:
- einen Stapel aus elektrochemische Zellen (2), von denen jede zwei Elektroden (3, 4) umfasst, die voneinander durch einen Elektrolyten (5) getrennt sind und in elektrischem Kontakt mit zweipoligen Platten (10, 20) sind, und mindestens ein Anschlagelement (7; 8; 14, 24) oder eine durchgehende Anschlagöffnung (15, 25) einer elektrochemische Zelle umfassen und
- mindestens einen elektrischen Verbinder (30), der eine elektrische Verbindung mit der elektrochemische Zelle (2) des Stapels aus elektrochemischen Zellen gewährleistet, wobei der elektrische Verbinder ein Endstück (50) umfasst, das in den Stapel aus elektrochemischen Zellen eingefügt ist und eine sogenannte Eingriffsposition einnimmt, wobei das Endstück umfasst:
o einen elektrischen Kontaktabschnitt (60), der in elektrischem Kontakt mit einer zweipoligen Platte (10; 20) der elektrochemischen Zelle (2) ist, wenn das Endstück (50) die Eingriffsposition einnimmt, und
o einen Blockierabschnitt (70), der mit der elektrochemischen Zelle (2) zusammenwirkt, um ein Halten des Endstücks (50) in der Eingriffsposition zu gewährleisten,
**dadurch gekennzeichnet, dass** der Blockierabschnitt (70) umfasst:
▪ entweder eine durchgehende Blockieröffnung (71), die durch Einfügen das Anschlagelement (7; 8; 14, 24) der elektrochemischen Zelle aufnimmt,
▪ oder ein Blockierelement (73), das durch Einfügen in die durchgehende Anschlagöffnung (15; 25) der elektrochemischen Zelle eingeführt wird,
wobei das Einfügen zur Bildung eines Anschlags führt, der sich dem Zurückziehen des Endstücks (50) aus der Eingriffsposition widersetzt,
und dass das Endstück (50) aus einem Stromkabel gebildet wird, das eine bandförmige leitende Seele (32) umfasst, die zwei zueinander entgegengesetzte Seiten umfasst, welche mit einem isolierenden Mantel (33) überzogen sind, und eine durchschnittliche Dicke zwischen zwei im Wesentlichen parallelen und einander entgegengesetzten Hauptseiten des Endstücks (50) aufweist, die geringer als die Abmessungen der Hauptseiten in der Breite und in der Länge ist.

2. Elektrochemischer Reaktor nach Anspruch 1, bei dem sich der isolierende Mantel (33) an den elektrischen Kontaktabschnitten (60) und Blockierabschnitten (70) auf den beiden Hauptseiten des Endstücks (33) erstreckt.

3. Elektrochemischer Reaktor nach Anspruch 1 oder 2, bei dem das Endstück (50) eine durchschnittliche Dicke zwischen 20 µm und 500 µm aufweist.

4. Elektrochemischer Reaktor nach einem der Ansprüche 1 bis 3, bei dem sich die durchgehende Blockieröffnung (71) oder das Blockierelement (73) entlang einer Dickenrichtung des Endstücks (50) erstreckt und durch den isolierenden Mantel (33) von der leitenden Seele (32) elektrisch isoliert ist.

5. Elektrochemischer Reaktor nach einem der Ansprüche 1 bis 4, wobei der elektrische Kontaktabschnitt (60) und der Blockierabschnitt (70) voneinander verschieden sind und entlang einer Längsachse des elektrischen Verbinders wechselseitig beabstandet sind.

6. Elektrochemischer Reaktor nach einem der Ansprüche 1 bis 5, bei dem der elektrische Kontaktabschnitt (60) eine der zweipoligen Platte (10, 20) zugewandte Hauptseite (61) umfasst, die einen Bereich ohne isolierenden Mantel (33) aufweist, so dass eine Kontaktfläche (62) der leitenden Seele (32) freigelegt ist, wobei die Kontaktfläche (62) mit der zweipoligen Platte (10; 20) in elektrischem Kontakt ist.

7. Elektrochemischer Reaktor nach Anspruch 6, bei dem die der Hauptseite (61) der leitenden Seele (32) entgegengesetzte Seite mit dem isolierenden Mantel (33) überzogen ist.

8. Elektrochemischer Reaktor nach Anspruch 6 oder 7, bei dem die Kontaktfläche (62) der leitenden Seele (32) mindestens eine Strukturierung (63) aufweist, die gegenüber einer Hauptebene, entlang der sich die Kontaktfläche (62) der leitenden Seele im Wesentlichen erstreckt, vorspringt, wobei die vorspringende Strukturierung (63) bevorzugt elastisch verformbar ist.

9. Elektrochemischer Reaktor nach einem der Ansprüche 1 bis 8, bei dem der Blockierabschnitt (70) eine durchgehende Blockieröffnung (71) umfasst, die geeignet ist, ein Anschlagelement aufzunehmen, das unter einem den Stapel aus elektrochemischen Zellen durchquerenden Zentrierer (7), einem angebrachten Einsatz (8) und einer Erhebung (14, 24), die durch die zweipolige Platte gebildet wird, gewählt ist.

10. Elektrochemischer Reaktor nach Anspruch 9, bei dem der Blockierabschnitt (70) einen durchgehenden Spalt (72) aufweist, der sich von der durchgehenden Blockieröffnung (71) aus bis zu einer seitlichen Kante (74) des Blockierabschnitts erstreckt, wobei der durchgehende Spalt eine Breite aufweist, die im Wesentlichen geringer als der Durchmesser der durchgehenden Blockieröffnung ist.

11. Elektrochemischer Reaktor nach Anspruch 9, bei dem sich die durchgehende Blockieröffnung (71) des Blockierabschnitts (70) bis zu einer seitlichen Kante (74) des Blockierabschnitts an einem Mündungsbereich (75) der Blockieröffnung (71) erstreckt, wobei dieser zwischen der durchgehenden Blockieröffnung (71) und dem elektrischen Kontaktabschnitt (60) angeordnet ist.

12. Elektrochemischer Reaktor nach einem der Ansprüche 1 bis 8, bei dem der Blockierabschnitt (70) ein Blockierelement (73) in Form einer Erhebung umfasst, die geeignet ist, in eine durchgehenden Anschlagöffnung (15; 25) der elektrochemische Zelle eingefügt zu werden.

13. Elektrochemischer Reaktor nach einem der Ansprüche 1 bis 12, umfassend eine Vielzahl verschiedener Endstücke (50), die eine elektrische Verbindung mit verschiedenen zweipoligen Platten (10, 20) gewährleisten, wobei die Endstücke mechanisch mit demselben äußeren Stück (40) des elektrischen Verbinders verbunden sind.

14. Elektrochemischer Reaktor nach einem der Ansprüche 1 bis 13, bei dem die zweipoligen Platten (10, 20) Kontakterhebungen (13, 23) umfassen, die bevorzugt elastisch verformbar sind, wobei das Endstück (50) einen Kontaktabschnitt (60) umfasst, der mit den Kontakterhebungen (13, 23) in Kontakt ist.

15. Verfahren zur Ausführung eines elektrochemischen Reaktors (1) nach einem der Ansprüche 1 bis 14, umfassend einen Schritt der Bildung des Stapels aus elektrochemischen Zellen, während dessen der elektrische Verbinder so zwischen zwei Stapeln aus zweipoligen Platten (10, 20) gestapelt wird, dass das Endstück die Eingriffsposition einnimmt, was sich äußert durch:
- einen elektrischen Kontakt zwischen dem elektrischen Kontaktabschnitt (60) und einer zweipoligen Platte (10, 20) und
- der Bildung eines Anschlags, der sich dem Zurückziehen des Endstücks aus der Eingriffsposition durch das Einfügen des Anschlagelements (7; 8; 14, 24) in die durchgehende Blockieröffnung (71) oder durch das Einfügen des Blockierelements (73) in die durchgehende Anschlagöffnung (15, 25) widersetzt.

## Claims

1. Electrochemical reactor (1), comprising:
- a stack of electrochemical cells (2) each comprising two electrodes (3, 4) separated from each other by an electrolyte (5) and in electrical contact with bipolar plates (10, 20), and comprising at least one abutment mechanism (7; 8; 14, 24) or an abutting through-orifice (15, 25) of an electrochemical cell; and
- at least one electrical connector (30), providing an electrical connection with the said electrochemical cell (2) of the said stack of electrochemical cells, the electrical connector comprising an end part (50) inserted into the stack of electrochemical cells and occupying a position referred to as engaged, the said end part comprising:
o an electrical contact portion (60), being in electrical contact with a bipolar plate (10; 20) of the said electrochemical cell (2) when the end part (50) occupies the engaged position; and
o a blocking portion (70), cooperating with the said electrochemical cell (2) in order to ensure the maintenance of the end part (50) in the engaged position,
**characterized in that** the blocking portion (70) comprises:
▪ either a blocking through-orifice (71) receiving by insertion the said abutment mechanism (7; 8; 14, 24) of the electrochemical cell,
▪ or a blocking mechanism (73) introduced by insertion into the said abutting through-orifice (15; 25) of the electrochemical cell,
the said insertion, leading to the formation of an abutment opposing the retraction of the end part (50) out of the engaged position,
and **in that** the end part (50) is composed of an electrical cable comprising a conducting core (32) in the form of a strip having two faces opposite to each other coated with an insulating sheath (33), and has an average thickness, between two main faces of the end part (50) substantially parallel and opposite to each other, less than the width and length dimensions of the said main faces.

2. Electrochemical reactor according to Claim 1, in which the said insulating sheath (33) extends over the electrical contact (60) and blocking (70) portions on the said two main faces of the end part (33).

3. Electrochemical reactor according to Claim 1 or 2, in which the end part (50) has an average thickness in the range between 20µm and 500µm.

4. Electrochemical reactor according to any one of Claims 1 to 3, in which the said blocking through-orifice (71) or the said blocking mechanism (73) runs in a thickness direction of the end part (50), and is electrically isolated from the conducting core (32) by the said insulating sheath (33).

5. Electrochemical reactor according to any one of Claims 1 to 4, in which the electrical contact portion (60) and the blocking portion (70) are distinct from each other and mutually spaced out along a longitudinal axis of the electrical connector.

6. Electrochemical reactor according to any one of Claims 1 to 5, in which the electrical contact portion (60) comprises a main face (61), oriented towards the said bipolar plate (10, 20), having a region not having any insulating sheath (33) freeing up a contact surface (62) of the conducting core (32), the said contact surface (62) being in electrical contact with the said bipolar plate (10; 20).

7. Electrochemical reactor according to Claim 6, in which the face of the conducting core (32) opposite to the main face (61) is coated with the insulating sheath (33).

8. Electrochemical reactor according to either of Claims 6 and 7, in which the said contact surface (62) of the conducting core (32) has at least one structural arrangement making a protrusion (63) with respect to a main plane in which the contact surface (62) of the conducting core substantially extends, the said protruding structural arrangement (63) being preferably elastically deformable.

9. Electrochemical reactor according to any one of Claims 1 to 8, in which the blocking portion (70) comprises a blocking through-orifice (71) adapted to receive an abutment mechanism chosen from amongst a centring pin (7) passing through the stack of electrochemical cells, a removable insert (8), and an embossment (14, 24) formed by the said bipolar plate.

10. Electrochemical reactor according to Claim 9, in which the blocking portion (70) comprises a open slot (72) extending from the said blocking through-orifice (71) up to a lateral edge (74) of the blocking portion, the said open slot having a width substantially less than the diameter of the blocking through-orifice.

11. Electrochemical reactor according to Claim 9, in which the said blocking through-orifice (71) of the blocking portion (70) extends up to a lateral edge (74) of the blocking portion at an opening area (75) of the said blocking orifice (71), the latter being positioned between the blocking through-orifice (71) and the electrical contact portion (60).

12. Electrochemical reactor according to any one of Claims 1 to 8, in which the blocking portion (70) comprises a blocking mechanism (73) in the form of an embossment designed to be inserted into an abutting through-orifice (15; 25) of the electrochemical cell.

13. Electrochemical reactor according to any one of Claims 1 to 12, comprising a plurality of separate end parts (50) providing an electrical connection with various bipolar plates (10, 20), the said end parts being mechanically connected to the same part, referred to as external part, (40) of the electrical connector.

14. Electrochemical reactor according to any one of Claims 1 to 13, in which the said bipolar plates (10, 20) comprise contact embossments (13, 23), preferably elastically deformable, the end part (50) comprising a contact portion (60) in contact with the said contact embossments (13, 23).

15. Method for implementing an electrochemical reactor (1) according to any one of Claims 1 to 14, comprising a step for formation of the stack of electrochemical cells, during which, between two stacks of bipolar plates (10, 20), the electrical connector is stacked in such a manner that the end part occupies the engaged position, resulting in:
- an electrical contact between the electrical contact portion (60) and a bipolar plate (10, 20), and
- the formation of an abutment opposing the retraction of the end part out of the engaged position by the insertion of the said abutment mechanism (7; 8; 14, 24) into the blocking through-orifice (71) or by the insertion of the said blocking mechanism (73) into the said abutting through-orifice (15, 25).
